# EUROPÄISCHE PATENTSCHRIFT

(11) **EP 1 915 266 B1**
(45) Veröffentlichungstag und Bekanntmachung des Hinweises auf die Patenterteilung: **26.01.2011**
(21) Anmeldenummer: 06753284.6
(22) Anmeldetag: 23.06.2006
(51) Int. Cl.: B60H 1/00, H01L 35/00

(54) **HEIZGERÄT MIT THERMOELEKTRISCHER EINRICHTUNG**
HEATING APPARATUS COMPRISING A THERMOELECTRIC DEVICE
DISPOSITIF DE CHAUFFAGE A DISPOSITIF THERMOELECTRIQUE

(30) Priorität: 23.06.2005 DE 102005029184; 04.08.2005 DE 102005036768
(43) Veröffentlichungstag der Anmeldung: 30.04.2008
(73) Patentinhaber: Webasto AG, 82131 Stockdorf (DE)
(72) Erfinder: BUDDE, Jörn, 14471 Potsdam (DE); BAADE, Jens, 17033 Neubrandenburg (DE); STELTER, Michael, 09247 Röhrsdorf (DE)
(74) Vertreter: Willsau, Peter
(86) Internationale Anmeldenummer: PCT/DE2006/001079
(87) Internationale Veröffentlichungsnummer: WO 2006/136149

(56) Entgegenhaltungen:
- EP-A2- 1 332 897
- DE-B- 1 278 578
- US-A- 5 450 869

## Beschreibung

Die Erfindung betrifft ein Heizgerät mit einer Wandung, an deren Innenseite ein Bereich zur Führung heißer Abgase anschließt, einem Gehäuse, welches die Wandung zumindest teilweise umgibt und wobei ein Zwischenraum zwischen der Wandung und dem Gehäuse von einem zu erwärmenden Medium durchströmt wird, und einer in dem Zwischenraum angeordneten, mehrere Thermoelement-Schenkel aufweisenden thermoelektrischen Einrichtung, die geeignet ist, aufgrund einer Temperaturdifferenz zwischen den Abgasen und dem zu erwärmenden Medium, eine elektrische Spannung zu erzeugen, wobei die Wandung zumindest teilweise elektrisch isolierend ausgebildet ist, wobei die Thermoelement-Schenkel mit einem ersten Endbereich mittels elektrisch leitfähiger Schichten an einem Wärmekontaktabschnitt der Wandung befestigt sind, wobei ein zumindest teilweise elektrisch isolierender Wärmetauscher vorgesehen ist, der dem Wärmekontaktabschnitt der Wandung gegenüberliegend angeordnet ist, wobei die Thermoelement-Schenkel mit einem zweiten Endbereich mittels elektrisch leitfähiger Schichten an dem elektrisch isolierenden Wärmetauscher befestigt sind und wobei die elektrisch leitfähigen Schichten die jeweiligen Endbereiche der Thermoelement-Schenkel zumindest teilweise miteinander verbinden.

Ein Heizgerät mit einem thermoelektrischen Generator ist aus der DE 102 35 601 A1 bekannt. Durch die Möglichkeit, mit einer derartigen Vorrichtung Wärmeenergie in elektrische Energie umzuwandeln, gelingt es, die für den Betrieb des Heizgerätes erforderliche elektrische Energie, beispielsweise zur Versorgung eines Gebläses und einer Steuerung, im Heizgerät selbst zu erzeugen. Ebenfalls kann die so erzeugte elektrische Energie anderen Verbrauchern im Kraftfahrzeug zur Verfügung gestellt werden, beispielsweise durch eine Einspeisung in das elektrische Bordnetz. Die in der DE 102 35 601 A1 gezeigte Anordnung weist eine thermoelektrische Einrichtung in Form eines thermoelektrischen Moduls auf, das zwischen einem die "heiße Seite" bildenden ersten Wandungsabschnitt und einem die "kalte Seite" bildenden Wärmetauscher angeordnet ist. Bei Betrieb des Heizgerätes kann an dem thermoelektrischen Modul somit eine Spannung abgegriffen werden, wobei allerdings Probleme im Hinblick auf die Aufrechterhaltung möglichst hoher Temperaturdifferenzen, thermische Ausdehnungen und eine mangelhafte Wärmeleitfähigkeit zwischen dem thermoelektrischen Modul und dem Wandungsabschnitt beziehungsweise dem Wärmetauscher auftreten können.

Aus der US 5,450,869 ist ein Heizgerät gemäβ Oberbegriff des Anspruchs 1 mit einem thermoelektrischen Generator bekannt. Auch hier sind keine besonderen Maßnahmen zur Aufrechterhaltung möglichst hoher Temperaturdifferenzen zwischen einer Wärmequelle und einer Wärmesenke beschrieben.

Ein thermoelektrischer Generator ist weiterhin in der DE 1 278 578 offenbart.

Der Erfindung liegt die Aufgabe zugrunde, die Probleme des Standes der Technik zumindest teilweise zu überwinden und dabei insbesondere die thermischen und mechanischen Verhältnisse der Anordnung sowie die Gestaltungsmöglichkeiten im Aufbau zu verbessern.

Diese Aufgabe wird mit den Merkmalen des unabhängigen Anspruches gelöst.

Vorteilhafte Ausführungsformen der Erfindung sind in den abhängigen Ansprüchen angegeben.

Die Erfindung baut auf dem gattungsgemäßen Heizgerät dadurch auf, dass eine mechanische Verbindung zwischen der Wandung und dem Wärmetauscher ein wärmeisolierendes Material und eine Dichteinrichtung aufweist, so dass ein Zwischenraum zwischen dem Wärmekontaktabschnitt der Wandung und dem Wärmetauscher von dieser Dichteinrichtung umgeben ist und das Wärmeträgermedium nicht in den Zwischenraum eintreten kann. Es wird eine Anordnung aus einzelnen Thermoelement-Schenkeln gewählt, die sich über Schichten, insbesondere gedruckte metallische Leiterbahnen, direkt an der Wärmequelle beziehungsweise der Wärmesenke abstützen. Um dies zu ermöglichen, sind sowohl die Wandung beziehungsweise zumindest der Bereich der Wandung, an dem die Thermoelement-Schenkel angeordnet sind, und der Wärmeträger aus elektrisch isolierenden aber dennoch wärmeleitfähigen Materialien gefertigt. Die elektrischen Verhältnisse werden durch die Anordnung der elektrisch leitfähigen Schichten bestimmt, die den Endbereich der Thermoelement-Schenkel selektiv miteinander verbinden. Diese Anordnung schafft auch einen geeigneten Ausgangspunkt dafür, wie nachfolgend noch detailliert beschrieben wird, thermische Nebenschlüsse zwischen Wärmesenke und Wärmequelle zu vermeiden und eine ausreichende, mechanische Ausgleichsfähigkeit im Hinblick auf thermische Ausdehnungen zu schaffen. Durch das wärmeisolierende Material zwischen Wandung und Wärmetauscher wird ein unerwünschter Wärmeausgleich zwischen der Wandung und dem Wärmetauscher vermieden, so dass die thermoelektrische Einrichtung mit hohem Wirkungsgrad arbeiten kann.

Es ist bevorzugt, dass die Wandung zumindest teilweise aus einer elektrisch isolierenden Keramik mit hoher Wärmeleitfähigkeit besteht.

Ebenso ist es vorteilhaft, dass der elektrisch isolierende Wärmetauscher zumindest teilweise aus einer Keramik mit hoher Wärmeleitfähigkeit besteht.

Beispielsweise kann vorgesehen sein, dass die Keramik für die Wandung und/oder für den elektrisch isolierenden Wärmetauscher Aluminiumnitrid aufweist. Derartige Keramiken können die Anforderungen einer hohen Wärmeleitfähigkeit bei gleichzeitiger elektrischer Isolierung erfüllen. Außerdem lassen sich die gedruckten Leiterbahnen beispielsweise aus Aluminium fertigen, wodurch aufgrund der hohen Affinität zwischen Aluminium und Aluminiumnitrid die Verbindung zwischen den Thermoelement-Schenkeln und den Befestigungspunkten stabilisiert wird.

Im Hinblick auf die elektrische Auslegung der Anordnung kann vorgesehen sein, dass die elektrisch leitfähigen Schichten die Thermoelement-Schenkel miteinander in Reihe schalten.

Ebenso ist es möglich, dass die elektrisch leitfähigen Schichten die Thermoelement-Schenkel zueinander parallel schalten.

In Weiterbildung der genannten Ausführungsformen kann ebenfalls vorgesehen sein, dass die elektrisch leitfähigen Schichten Gruppen von Thermoelement-Schenkeln zueinander parallel schalten und diese Gruppen miteinander in Reihe schalten. Je nach den elektrischen Bedürfnissen, können so durch die Reihenschaltung der Thermoelement-Schenkel die bei gegebenen Temperaturverhältnissen gewünschten Spannungen erzeugt werden, wobei aufgrund der Parallelschaltung einzelner Thermoelement-Schenkel beziehungsweise der zu Gruppen zusammengefassten Thermoelement-Schenkel ausreichend hohe Ströme zur Verfügung gestellt werden.

Gemäß einer bevorzugten Ausführungsform ist vorgesehen, dass das zu erwärmende Medium flüssig, insbesondere Wasser ist und dass der Wärmekontaktabschnitt einem Flammrohrende gegenüberliegt.

Die Erfindung kann also im Rahmen eines sogenannten Wasserheizgerätes eingesetzt werden. In diesem Fall ist es nützlich, den Wärmekontaktabschnitt gegenüberliegend zu einem Flammrohrende vorzusehen, das heißt im Bereich des Brennerbodens. An dieser Stelle treten die höchsten Temperaturen auf, so dass die thermoelektrische Einrichtung mit hohem Wirkungsgrad arbeiten kann.

Nützlicherweise ist vorgesehen, dass ein die Thermoelement-Schenkel aufnehmender Zwischenraum zwischen der Wandung und dem elektrisch isolierenden Wärmetauscher gegen den Eintritt des flüssigen zu erwärmenden Mediums mittels einer Dichteinrichtung abgedichtet ist und dass die Dichteinrichtung geeignet ist, thermisch bedingte Ausdehnungen auszugleichen. Die Dichtung stellt somit gleichzeitig sicher, dass kein Wasser mit den Thermoelement-Schenkeln in Berührung kommt und dass eine ausreichende, mechanische Flexibilität zum Ausgleich thermischer Ausdehnungen zur Verfügung gestellt wird. Die Dichtung kann insbesondere zwei Komponenten aufweisen. Die eine Komponente ist im Hinblick auf die Wärmeisolierung optimiert, die andere Komponente dient der Bereitstellung der nützlichen thermische Ausdehnungen kompensierenden Elastizität. Bei geeigneter Materialauswahl können diese beiden Komponenten in Form einer einheitlichen Komponente realisiert sein, das heißt in Form einer gut wärmeisolierenden elastischen Dichtung. Eine derartige Compound-Dichtung kann beispielsweise als Silikon-Al₂O₃-Dichtung ausgebildet sein.

Gemäß einer weiteren bevorzugten Ausführungsform ist vorgesehen, dass das zu erwärmende Medium gasförmig, insbesondere Luft ist und dass der Wärmekontaktabschnitt im Bereich eines Eintritts für das gasförmige zu erwärmende Medium liegt. Die Erfindung lässt sich also auch im Rahmen sogenannter Luftheizgeräte realisieren. Da im Bereich des Lufteintritts die Luft die geringste Temperatur hat, sich jedoch beim Durchtritt durch das Heizgerät rasch erwärmt, ist es zur Realisierung eines möglichst hohen thermoelektrischen Wirkungsgrades nützlich, die thermoelektrische Einrichtung im Bereich des Lufteintritts anzuordnen.

Im Zusammenhang mit dieser Anordnung der thermoelektrischen Einrichtung im Luftheizgerät ist nützlicherweise vorgesehen, dass ein die Thermoelement-Schenkel aufnehmender Zwischenraum zwischen der Wandung und dem elektrisch isolierenden Wärmetauscher gegen den Eintritt des gasförmigen zu erwärmenden Mediums mittels einer Windschürze geschützt ist. Da durch die Berührung der Thermoelement-Schenkel mit Kaltluft die Funktionsfähigkeit der Einrichtung negativ beeinflusst würde, stellt die einfache Maßnahme einer Windschürze eine nützliche Weiterbildung der Erfindung dar.

Gemäß einer weiteren Ausführungsform der Erfindung muss vorgesehen sein, dass sich die thermoelektrische Einrichtung über eine elastische Verbindung an dem Gehäuse abstützt. Durch diese Lagerung der thermoelektrischen Einrichtung wird eine Verbesserung des Ausgleichs thermisch bedingter Ausdehnungen zur Verfügung gestellt. Die thermoelektrische Einrichtung wird so stabil gehalten, die elastische Lagerung stellt aber eine ausreichende Flexibilität zur Verfügung.

Beispielsweise kann dies so realisiert sein, dass sich die thermoelektrische Einrichtung über einen Wärmetauscher und elastische Mittel an dem Gehäuse abstützt. Der von dem flüssigen oder gasförmigen Wärmeträgermedium umströmte Wärmetauscher kann somit die Aufgabe der Bereitstellung einer elastischen Verbindung übernehmen.

In Weiterbildung dieses Gedankens kann vorgesehen sein, dass sich die thermoelektrische Einrichtung über einen Wärmetauscher und eine den Wärmetauscher abstützende mit elastischen Mittel ausgestattete Platte an dem Gehäuse abstützt.

In diesem Zusammenhang ist es möglich, dass der Wärmetauscher und die mit elastischen Mittel ausgestattete Platte einstückig ausgebildet sind.

Eine einfache und wirkungsvolle Realisierung dieser thermische Ausdehnungen kompensierenden Anordnungen sieht vor, dass die elastische Verbindung Tellerfedern umfasst.

Beispielsweise kann vorgesehen sein, dass das wärmeisolierende Material Aluminiumoxid und/oder Mullit enthält.

Weiterhin ist es nützlich, dass die Verbindung zwischen dem ersten Gehäuse und dem Wärmetauscher eine Dichtung aufweist, die geeignet ist, die thermoelektrische Einrichtung gegen das zu erwärmende Medium abzudichten und thermisch bedingte Ausdehnungen auszugleichen.

Ebenfalls ist es möglich, dass die Wandung und das wärmeisolierende Material und/oder die Dichteinrichtung einstückig ausgebildet sind.

In vergleichbarer Wiese kann vorgesehen sein, dass der Wärmetauscher und das wärmeisolierende Material und/oder die Dichteinrichtung einstückig ausgebildet sind. Die Möglichkeit, diese einstückigen Ausbildungen zu realisieren hängt wiederum von der geeigneten Materialauswahl für die verwendeten Bauteile ab.

Zur weiteren Verbesserung der thermoelektrischen Eigenschaften ist vorgesehen, dass zwischen der thermoelektrischen Einrichtung und der Wandung und/oder zwischen der thermoelektrischen Einrichtung und dem Wärmetauscher ein Wärmeleitmittel vorgesehen ist. Durch ein solches Wärmeleitmittel werden die Thermoelement-Schenkel in verbesserter Weise thermisch an die Wärmequelle und die Wärmesenke angebunden.

Dies kann beispielsweise dadurch realisiert sein, dass das Wärmeleitmittel eine Wärmeleitpaste aufweist.

Eine andere Möglichkeit besteht darin, dass das Wärmeleitmittel eine Wärmeleitfolie aufweist.

Die Erfindung wird nun mit Bezug auf die begleitenden Zeichnungen anhand einer bevorzugten Ausführungsform beispielhaft erläutert.

Dabei zeigen:
- Figur 1: eine teilweise Schnittansicht eines erfindungsge- mäßen Heizgerätes;
- Figur 2: eine Einzelheit eines erfindungsgemäßen Heizgerä- tes;
- Figur 3: eine teilweise Schnittansicht einer weiteren Aus- führungsform eines erfindungsgemäßen Heizgerätes; und
- Figur 4: eine teilweise Schnittansicht einer weiteren Aus- führungsform eines Heizgerätes.

Bei der nachfolgenden Beschreibung der Zeichnungen bezeichnen gleiche Bezugszeichen gleiche oder vergleichbare Komponenten.

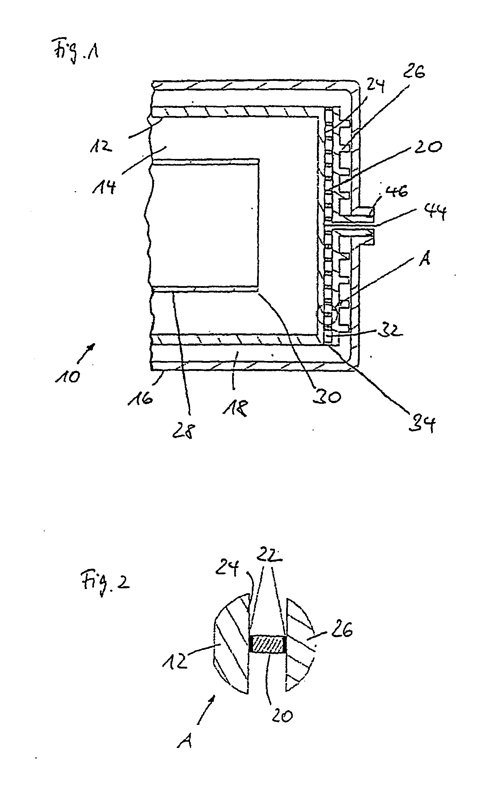

Figur 1 zeigt eine teilweise Schnittansicht eines erfindungsgemäßen Heizgerätes; Figur 2 zeigt eine Einzelheit eines erfindungsgemäßen Heizgerätes. Das Heizgerät 10, das heißt insbesondere die in Figur 1 dargestellte Wärmetauscheranordnung ist im Wesentlichen axialsymmetrisch aufgebaut, wobei eine innere Wandung 12 und ein äußeres Gehäuse 16 vorgesehen sind. Innerhalb der Wandung 12 ist ein Flammrohr 28 angeordnet, wobei aus dem Flammrohr 28 austretende Abgase die Innenseite der Wandung 12 erwärmen. Zwischen der Wandung 12 und dem Gehäuse 16 ist ein Zwischenraum 18 vorgesehen, der durch ein Wärmeträgermedium, beispielsweise Wasser, durchströmt wird, so dass due Wandung 12 als Wärmetauscher zur Übertragung von Verbrennungswärme auf das Wärmeträgermedium fungiert. An einem Boden der Wandung 12, der als Wärmekontaktabschnitt 24 vorgesehen ist, sind mehrere Thermoelement-Schenkel 20 angeordnet. Die Thermoelement-Schenkel 20 stehen über elektrisch leitfähige Schichten 22 mit dem Wärmekontaktabschnitt 24 der Wandung 12 mit jeweils einem Endbereich in Verbindung. Über die anderen Endbereichen der Thermoelement-Schenkel 20 stehen diese mit einem Wärmetauscher 26 in Verbindung, der in dem Zwischenraum 18 zwischen der Wandung 12 und dem Gehäuse 16 angeordnet ist. Der Zwischenraum 32 zwischen dem Wärmekontaktabschnitt 24 und dem Wärmetauscher 26 ist von einer Dichteinrichtung 34 umgeben, die beispielsweise eine Dichtung sein kann, so dass das Wärmeträgermedium nicht in dem Zwischenraum 32 eintreten kann. Die grundsätzliche Anbindung der Thermoelement-Schenkel 20 über die elektrisch leitfähigen Schichten ist in der Einzelheit A in Figur 2 dargestellt. Die elektrisch leitfähigen Schichten 22 dienen dazu, die Thermoelement-Schenkel 20 miteinander elektrisch selektiv zu verbinden. Dies gelingt, da sowohl die Wandung 12 beziehungsweise zumindest der Wärmekontaktabschnitt 24 und zumindest teilweise der Wärmetauscher 26 aus elektrisch isolierendem Material gefertigt sind, das aber sehr wohl eine ausreichende Wärmeleitfähigkeit für den Betrieb der thermoelektrischen Einrichtung aufweist. Über die elektrisch leitfähigen Schichten 22 sind dann beispielsweise zwei benachbarte Thermoelement-Schenkel 20 auf ihrer der Wandung 12 zugewandten Seite miteinander verbunden, während der nächste Thermoelement-Schenkel auf der dem Wärmetauscher 26 zugewandten Seite elektrisch angebunden ist. Der nächste Thermoelement-Schenkel 20 ist wiederum auf der der Wandung 12 zugewandten Seite elektrisch angebunden, und so weiter. Wählt man diese elektrische Anbindung, so liegt eine Reihenschaltung der Thermoelement-Schenkel 20 vor. Folglich lässt sich der Anordnung unter Verwendung der elektrischen Verbindung 44 eine Thermospannung entnehmen, die die Summe der Thermospannungen der einzelnen Thermoelement-Schenkel 20 darstellt. Ebenfalls ist es möglich, die Thermoelement-Schenkel in Gruppen elektrisch parallel zu schalten und diese Gruppen dann in Reihe zu schalten. Auf diese Weise ist bei geringer Spannung eine erhöhte Stromausbeute möglich. Der elektrisch isolierende Wärmetauscher 26 steht im Bereich des elektrischen Anschlusses 44 mit dem Gehäuse 16 in Verbindung. Die Verbindung wird über eine Dichtung 46 vermittelt.

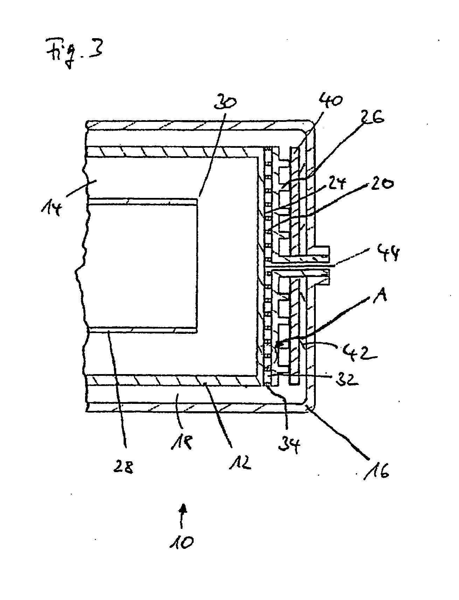

Figur 3 zeigt eine teilweise Schnittansicht einer weiteren Ausführungsform eines erfindungsgemäßen Heizgerätes. Die Ausführungsform des erfindungsgemäßen Heizgerätes 10 gemäß Figur 3 unterscheidet sich von der im Zusammenhang mit Figur 1 beschriebenen Ausführungsform dadurch, dass sich der Wärmetauscher 26 über eine mit Tellerfedern 42 ausgestattete Platte 40 am Gehäuse 16 abstützt. Hierdurch steht eine stabile Anordnung zur Verfügung, wobei durch geeignete Auslegung der Federkräfte ein sicherer thermischer Kontakt zwischen den Thermoelement-Schenkeln und der Wandung 12 sowie dem Wärmetauscher 26 zur Verfügung steht. Im Hinblick auf den Wärmekontakt kann vorteilhafterweise noch vorgesehen sein, dass zwischen den Thermoelement-Schenkeln 20 und der Wandung 12 beziehungsweise dem Wärmetauscher 26 ein Wärmeleitmittel, beispielsweise eine Wärmeleitpaste oder eine Wärmeleitfolie, vorgesehen ist.

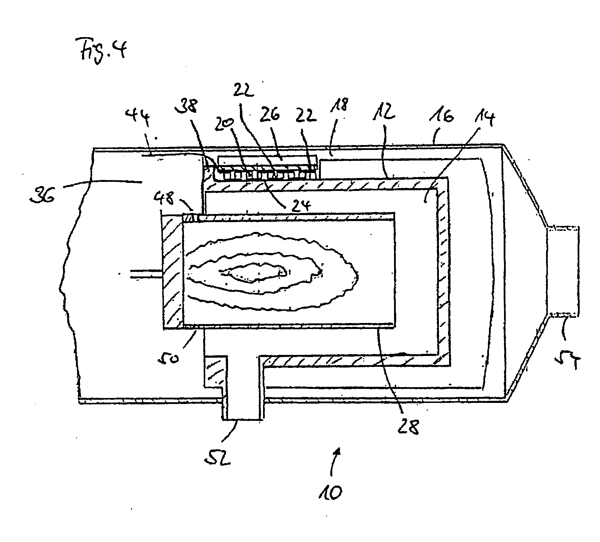

Bei den Ausführungsformen gemäß Figur 1 und Figur 3 ist die thermoelektrische Einrichtung in dem Bereich angeordnet, in dem die höchsten Abgastemperaturen zur Verfügung stehen. Bei der Ausführungsform gemäß Figur 4, die ein Luftheizgerät betrifft, ist dies anders, was mit Bezug auf die nachfolgende Zeichnung beschrieben wird.

Figur 4 zeigt eine teilweise Schnittansicht einer weiteren Ausführungsform eines Heizgerätes. Zusätzlich zu den bereits im Zusammenhang mit den Figuren 1 bis 3 beschriebenen Komponenten sind eine Brennstoffzuführung, Brennluftöffnungen 48, 50, ein Abgasauslass 52 und ein Warmluftauslass 54 zu erkennen. Im Gegensatz zu dem in Zusammenhang mit den Figuren 1 bis 3 beschriebenen Ausführungsformen, die ein Wasserheizgerät betreffen, ist in Figur 4 ein Luftheizgerät dargestellt, wobei hier der Wärmekontaktabschnitt 24 der Wandung 12 im Bereich des Lufteintritts 36 angeordnet ist. Auf diese Weise kommt der Wärmetauscher 26 mit der kalten eintretenden Luft in Berührung, so dass die verschiedenen Seiten der Thermoelement-Schenkel 20 eine möglichst große Temperaturdifferenz aufweisen. Bei der dargestellten Ausführungsform sind die Thermoelemete 20 über die elektrisch leitfähigen Schichten 22 in Reihe geschaltet. Bezüglich der anderen Schaltungsvarianten wird auf die Ausführungen zu den Figuren 1 bis 3 hingewiesen. Die Schaltungsvarianten sollten vorzugsweise so gewählt werden, dass die bei gängigen Temperaturdifferenzen auftretenden Spannungen derart sind, dass ohne zusätzliche Gleichspannungswandlung die vom Thermoelement-Schenkel abgegebene Spannung genutzt werden kann, sei es für Komponenten des Luftheizgerätes oder andere Fahrzeugkomponenten, beispielsweise über Einspeisung ins Bordnetz.

### Bezugszeichenliste:

- 10: Heizgerät
- 12: Wandung
- 14: Bereich
- 16: Gehäuse
- 18: Zwischenraum
- 20: Thermoelement-Schenkel
- 22: elektrisch leitfähige Schichten
- 24: Wärmekontaktabschnitt
- 26: Wärmetauscher
- 28: Flammrohr
- 30: Flammrohrende
- 32: Zwischenraum
- 34: Dichteinrichtung
- 36: Lufteintritt
- 38: Windschürze
- 40: Platte
- 42: Tellerfeder
- 44: elektrische Verbindung
- 46: Dichtung
- 48: Brennluftöffnung
- 50: Brennluftöffnung
- 52: Abgasauslass
- 54: Warmluftauslass

## Patentansprüche

1. Heizgerät (10) mit
- einer Wandung (12), an deren Innenseite ein Bereich (14) zur Führung heißer Abgase anschließt,
- einem Gehäuse (16), welches die Wandung zumindest teilweise umgibt und wobei ein Zwischenraum (18) zwischen der Wandung und dem Gehäuse von einem zu erwärmenden Medium durchströmt wird, und
- einer in dem Zwischenraum angeordneten, mehrere Thermoelement-Schenkel (20) aufweisenden thermoelektrischen Einrichtung, die geeignet ist, aufgrund einer Temperaturdifferenz zwischen den Abgasen und dem zu erwärmenden Medium, eine elektrische Spannung zu erzeugen,
- wobei die Wandung (12) zumindest teilweise elektrisch isolierend ausgebildet ist,
- wobei die Thermoelement-Schenkel (20) mit einem ersten Endbereich mittels elektrisch leitfähiger Schichten (22) an einem Wärmekontaktabschnitt (24) der Wandung befestigt sind,
- wobei ein zumindest teilweise elektrisch isolierender Wärmetauscher (26) vorgesehen ist, der dem Wärmekontaktabschnitt (24) der Wandung (12) gegenüberliegend angeordnet ist,
- wobei die Thermoelement-Schenkel (20) mit einem zweiten Endbereich mittels elektrisch leitfähiger Schichten (22) an dem elektrisch isolierenden Wärmetauscher (26) befestigt sind und
- wobei die elektrisch leitfähigen Schichten (22) die jeweiligen Endbereiche der Thermoelement-Schenkel (20) zumindest teilweise miteinander verbinden,
**dadurch gekennzeichnet, dass**eine mechanische Verbindung zwischen der Wandung und dem Wärmetauscher ein wärmeisolierendes Material und eine Dichteinrichtung (34) aufweist, so dass ein Zwischenraum (32) zwischen dem Wärmekontaktabschnitt (24) der Wandung (12) und dem Wärmetauscher (26) von dieser Dichteinrichtung (34) umgeben ist und das Wärmeträgermedium nicht in den Zwischenraum (32) eintreten kann.

2. Heizgerät nach Anspruch 1, **dadurch gekennzeichnet, dass** die Wandung (12) zumindest teilweise aus einer elektrisch isolierenden Keramik mit hoher Wärmeleitfähigkeit besteht.

3. Heizgerät nach Anspruch 1 oder 2, **dadurch gekennzeichnet, dass** der elektrisch isolierende Wärmetauscher (26) zumindest teilweise aus einer Keramik mit hoher Wärmeleitfähigkeit besteht.

4. Heizgerät nach Anspruch 2 oder 3, **dadurch gekennzeichnet, dass** die Keramik für die Wandung (12) und/oder für den elektrisch isolierenden Wärmetauscher (26) Aluminiumnitrid aufweist.

5. Heizgerät nach einem der vorhergehenden Ansprüche, **dadurch gekennzeichnet, dass** die elektrisch leitfähigen Schichten (22) die Thermoelement-Schenkel (20) miteinander in Reihe schalten.

6. Heizgerät nach Anspruch 1 bis 4, **dadurch gekennzeichnet, dass** die elektrisch leitfähigen Schichten (22) die Thermoelement-Schenkel (20) zueinander parallel schalten.

7. Heizgerät nach Anspruch 1 bis 4, **dadurch gekennzeichnet, dass** die elektrisch leitfähigen Schichten (22) Gruppen von Thermoelement-Schenkeln (20) zueinander parallel schalten und diese Gruppen miteinander in Reihe schalten.

8. Heizgerät nach einem der vorhergehenden Ansprüche, **dadurch gekennzeichnet,**
- **dass** das zu erwärmende Medium flüssig, insbesondere Wasser ist und
- **dass** der Wärmekontaktabschnitt (24) einem Flammrohrende (30) gegenüberliegt.

9. Heizgerät nach Anspruch 8, **dadurch gekennzeichnet, dass** die Dichteinrichtung (34) geeignet ist, thermisch bedingte Ausdehnungen auszugleichen.

10. Heizgerät nach Anspruch 1 bis 7, **dadurch gekennzeichnet,**
- **dass** das zu erwärmende Medium gasförmig, insbesondere Luft ist und
- **dass** der Wärmekontaktabschnitt im Bereich eines Eintritts (36) für das gasförmige zu erwärmende Medium liegt.

11. Heizgerät nach Anspruch 10, **dadurch gekennzeichnet, dass** ein die Thermoelement-Schenkel (20) aufnehmender Zwischenraum zwischen der Wandung und dem elektrisch isolierenden Wärmetauscher gegen den Eintritt des gasförmigen zu erwärmenden Mediums mittels einer Windschürze (38) geschützt ist.

12. Heizgerät nach einem der vorhergehenden Ansprüche, **dadurch gekennzeichnet, dass** sich die thermoelektrische Einrichtung über eine elastische Verbindung (26, 40, 42) an dem Gehäuse (16) abstützt.

13. Heizgerät nach einem der vorhergehenden Ansprüche, **dadurch gekennzeichnet, dass** sich die thermoelektrische Einrichtung über einen Wärmetauscher (26) und elastische Mittel (42) an dem Gehäuse (16) abstützt.

14. Heizgerät nach einem der vorhergehenden Ansprüche, **dadurch gekennzeichnet, dass** sich die thermoelektrische Einrichtung über einen Wärmetauscher (26) und eine den Wärmetauscher abstützende mit elastischen Mittel (42) ausgestattete Platte (40) an dem Gehäuse (16) abstützt.

15. Heizgerät nach Anspruch 14, **dadurch gekennzeichnet, dass** der Wärmetauscher und die mit elastischen Mittel ausgestattete Platte einstückig ausgebildet sind.

16. Heizgerät nach einem der vorhergehenden Ansprüche, **dadurch gekennzeichnet, dass** die elastische Verbindung Tellerfedern (42) umfasst.

17. Heizgerät nach Anspruch 16, **dadurch gekennzeichnet, dass** das wärmeisolierende Material Aluminiumoxid und/oder Mullit enthält.

18. Heizgerät nach Anspruch 16 oder 17, **dadurch gekennzeichnet, dass** die Verbindung zwischen dem ersten Gehäuse und dem Wärmetauscher eine Dichtung (46) aufweist, die geeignet ist, die thermoelektrische Einrichtung gegen das zu erwärmende Medium abzudichten und thermisch bedingte Ausdehnungen auszugleichen.

19. Heizgerät nach Anspruch 18, **dadurch gekennzeichnet, dass** die Wandung und das wärmeisolierende Material und/oder die Dichteinrichtung einstückig ausgebildet sind.

20. Heizgerät nach Anspruch 18 oder 19, **dadurch gekennzeichnet, dass** der Wärmetauscher und das wärmeisolierende Material und/oder die Dichteinrichtung einstückig ausgebildet sind.

21. Heizgerät nach einem der vorhergehenden Ansprüche, **dadurch gekennzeichnet, dass** zwischen der thermoelektrischen Einrichtung und der Wandung (12) und/oder zwischen der thermoelektrischen Einrichtung und dem Wärmetauscher (26) ein Wärmeleitmittel vorgesehen ist.

22. Heizgerät nach Anspruch 21, **dadurch gekennzeichnet, dass** das Wärmeleitmittel eine Wärmeleitpaste aufweist.

23. Heizgerät nach Anspruch 21, **dadurch gekennzeichnet, dass** das Wärmeleitmittel eine Wärmeleitfolie aufweist.

## Claims

1. A heating apparatus (10), comprising
- a wall (12) which, at its inner side, adjoins a region (14) for routing hot exhaust gases,
- a housing (16) surrounding the wall at least partially, a medium to be heated flowing through an interspace (18) between the wall and the housing, and
- a thermoelectric device which is arranged in the interspace and comprises a plurality thermoelement legs (20) and which is suitable for generating an electrical voltage on account of a temperature difference between the exhaust gases and the medium to be heated,
- wherein the wall (12) is designed to be at least partially electrically insulating,
- wherein the thermoelement legs (20) are fastened, with a first end region, to a heat contact portion (24) of the wall via electrically conductive layers (22),
- wherein a heat exchanger (26) is provided which is at least partially electrically insulating and arranged opposite the heat contact portion (24) of the wall (12),
- wherein the thermoelement legs (20) are fastened, with a second end region, to the electrically insulating heat exchanger (26) via electrically conductive layers (22), and
- wherein the electrically conductive layers (22) connect the respective end regions of the thermoelement legs (20) at least partially to one another,
**characterized in that** a mechanical connection between the wall and the heat exchanger comprises a heat-insulating material and a sealing means (34), such that an interspace (32) between the heat contact portion (24) of the wall (12) and the heat exchanger (26) is surrounded by this sealing means (34) and the heat carrier medium may not enter the interspace (32).

2. The heating apparatus as set forth in claim 1, **characterized in that** the wall (12) consists at least partially of an electrically insulating ceramic having a high thermal conductivity.

3. The heating apparatus as set forth in claim 1 or 2, **characterized in that** the electrically insulating heat exchanger (26) consists at least partially of a ceramic having a high thermal conductivity.

4. The heating apparatus as set forth in claim 2 or 3, **characterized in that** the ceramic for the wall (12) and/or for the electrically insulating heat exchanger (26) comprises aluminum nitride.

5. The heating apparatus as set forth in any one of the preceding claims, **characterized in that** the electrically conductive layers (22) connect the thermoelement legs (20) in series with one another.

6. The heating apparatus as set forth in any one of claims 1 to 4, **characterized in that** the electrically conductive layers (22) connect the thermoelement legs (20) in parallel with one another.

7. The heating apparatus as set forth in any one of claims 1 to 4, **characterized in that** the electrically conductive layers (22) connect groups of thermoelement legs (20) in parallel with one another and connect these groups in series with one another.

8. The heating apparatus as set forth in any one of the preceding claims, **characterized in that**
- the medium to be heated is liquid, in particular water, and
- the heat contact portion (24) is arranged opposite a flame tube end (30).

9. The heating apparatus as set forth in claim 8, **characterized in that** the sealing means (34) is suitable for compensating thermally induced expansions.

10. The heating apparatus as set forth in any one of claims 1 to 7, **characterized in that**
- the medium to be heated is gaseous, in particular air, and
- the heat contact portion is arranged in the region of an inlet (36) for the gaseous medium to be heated.

11. The heating apparatus as set forth in claim 10, **characterized in that** an interspace, accommodating the thermoelement legs, between the wall and the electrically insulating heat exchanger is protected by means of a windbreak (38) against an ingress of the gaseous medium to be heated.

12. The heating apparatus as set forth in any one of the preceding claims, **characterized in that** the thermoelectric device is supported by the housing (16) via an elastic connection (26, 40, 42).

13. The heating apparatus as set forth in any one of the preceding claims, **characterized in that** the thermoelectric device is supported by the housing (16) via a heat exchanger (26) and elastic means (42).

14. The heating apparatus as set forth in any one of the preceding claims, **characterized in that** the thermoelectric device is supported by the housing (16) via a heat exchanger (26) and a plate (40) supporting the heat exchanger and equipped with elastic means (42).

15. The heating apparatus as set forth in claim 14, **characterized in that** the heat exchanger and the plate equipped with elastic means are produced in one piece.

16. The heating apparatus as set forth in one of the preceding claims, **characterized in that** the elastic connection comprises cup springs (42).

17. Heating apparatus as set forth in claim 16, **characterized in that** the heat-insulating material contains aluminum oxide and/or mullite.

18. The heating apparatus as set forth in claim 16 or 17, **characterized in that** the connection between the first housing and the heat exchanger comprises a seal (46) which is suitable for sealing off the thermoelectric device against the medium to be heated and for compensating thermally induced expansions.

19. The heating apparatus as set forth in claim 18, **characterized in that** the wall and the heat-insulating material and/or the sealing means are produced in one piece.

20. The heating apparatus as set forth in claim 18 or 19, **characterized in that** the heat exchanger and the heat-insulating material and/or the sealing means are produced in one piece.

21. The heating apparatus as set forth in any one of the preceding claims, **characterized in that** a heat conduction means is provided between the thermoelectric device and the wall (12) and/or between the thermoelectric device and the heat exchanger (26).

22. The heating apparatus as set forth in claim 21, **characterized in that** the heat conduction means comprises a heat conduction paste.

23. The heating apparatus as set forth in claim 21, **characterized in that** the heat conduction means comprises a heat conduction foil.

## Revendications

1. Appareil de chauffage (10), comportant
- un paroi (12), au côté intérieur duquel est raccordée une zone (14) pour conduire des gazes d'échappement,
- un boîtier (16) qui entoure le paroi au moins partiellement, un espace (18) entre le paroi et le boîtier étant traversé par un milieu à être chauffé, et
- un dispositif thermoélectrique, qui est agencé dans un espace intermédiaire et comporte plusieurs branches de thermoélément (20), et qui est apte à générer une tension électrique en raison d'une différence de température entre les gazes d'échappement et le milieu à être chauffé,
- le paroi (12) étant façonné à être au moins partiellement isolant d'électricité,
- les branches de thermoélément (20) étant fixées, avec une première zone terminale, à une partie de contact thermique (24) du paroi au moyen de couches (22) conductrices d'électricité,
- un échangeur de chaleur (26) étant prévu, qui est au moins partiellement isolant d'électricité et agencé en face de la partie de contact thermique (24) du paroi (12),
- les branches de thermoélément (20) étant fixées, avec une deuxième zone terminale, à l'échangeur de chaleur (26) isolant d'électricité au moyen de couches (22) conductrices d'électricité, et
- les couches (22) conductrices d'électricité raccordant les zones terminales respectives des branches de thermoélément (20) au moins partiellement l'une à l'autre,
**caractérisé en ce qu'**un raccord mécanique entre le paroi et l'échangeur de chaleur comporte un matériau isolant de chaleur et un moyen d'étanchéité (34), de sorte qu'un espace intermédiaire (32) entre la partie de contact thermique (24) du paroi (12) et l'échangeur de chaleur (26) est entouré par ce moyen d'étanchéité (34) et le milieu caloporteur ne peut pas entrer dans l'espace intermédiaire (32).

2. Appareil de chauffage selon la revendication 1, **caractérisé en ce que** le paroi (12) consiste au moins partiellement d'une céramique isolante d'électricité ayant une haute conductivité thermique.

3. Appareil de chauffage selon la revendication 1 ou 2, **caractérisé en ce que** l'échangeur de chaleur (26) isolant d'électricité consiste au moins partiellement d'une céramique ayant une haute conductivité thermique.

4. Appareil de chauffage selon la revendication 2 ou 3, **caractérisé en ce que** la céramique pour le paroi (12) et/ou pour l'échangeur isolant d'électricité (26) comporte du nitrure d'aluminium.

5. Appareil de chauffage selon l'une des revendications précédentes, **caractérisé en ce que** les couches (22) conductrices d'électricité couplent les branches de thermoélément (20) l'une avec l'autre en série.

6. Appareil de chauffage selon l'une des revendications 1 à 4, **caractérisé en ce que** les couches conductrices d'électricité (22) couplent les branches de thermoélément (20) l'une avec l'autre en parallèle.

7. Appareil de chauffage selon l'une des revendications 1 à 4, **caractérisé en ce que** les couches (22) conductrices d'électricité couplent des groupes de branches de thermoélément (20) l'une avec l'autre en parallèle et couplent ces groupes l'un avec l'autre en série.

8. Appareil de chauffage selon l'une des revendications précédentes, **caractérisé en ce que**
- le milieu à être chauffé est liquide, en particulier de l'eau, et
- la partie de contact thermique (24) est agencée en face d'un bout d'un tuyau de flamme (30).

9. Appareil de chauffage selon la revendication 8, **caractérisé en ce que** le moyen d'étanchéité (34) est apte à compenser des dilatations thermiques.

10. Appareil de chauffage selon l'une des revendications 1 à 7, **caractérisé en ce que**
- le milieu à être chauffé est gazeux, en particulier de l'air, et
- la partie de contact thermique est agencée dans la zone d'une entrée (36) pour le milieu gazeux à être chauffé.

11. Appareil de chauffage selon la revendication 10, **caractérisé en ce qu'**un espace intermédiaire, qui héberge les branches de thermoélément (20), entre le paroi et l'échangeur isolant d'électricité, est protégé, au moyen d'un brise-vent (38), contre l'entrée du milieu gazeux à être chauffé.

12. Appareil de chauffage selon l'une des revendications précédentes, **caractérisé en ce que** le dispositif thermoélectrique s'appuie sur le boîtier (16) à travers d'un raccord élastique (26, 40, 42).

13. Appareil de chauffage selon l'une des revendications précédentes, **caractérisé en ce que** le dispositif thermoélectrique s'appuie sur le boîtier (16) à travers d'un échangeur de chaleur (26) et de moyens élastiques (42).

14. Appareil de chauffage selon l'une des revendications précédentes, **caractérisé en ce que** le dispositif thermoélectrique s'appuie sur le boîtier (16) à travers d'un échangeur de chaleur (26) et d'une plaque (40) pourvue de moyens élastiques (42) et appuyant l'échangeur de chaleur.

15. Appareil de chauffage selon la revendication 14, **caractérisé en ce que** l'échangeur de chaleur et la plaque pourvue de moyens élastiques sont formés en une seule pièce.

16. Appareil de chauffage selon l'une des revendications précédentes, **caractérisé en ce que** le raccord élastique comporte des ressorts à disque (42).

17. Appareil de chauffage selon la revendication 16, **caractérisé en ce que** le matériau isolant de chaleur contient de l'oxyde d'aluminium et/ou de la mullite.

18. Appareil de chauffage selon la revendication 16 ou 17, **caractérisé en ce que** le raccord entre le premier boîtier et l'échangeur de chaleur comporte un joint d'étanchéité (46) qui est apte à étancher le dispositif thermoélectrique contre le milieu à être chauffé et à compenser des dilatations thermiques.

19. Appareil de chauffage selon la revendication 18, **caractérisé en ce que** le paroi et le matériau isolant de chaleur et/ou le moyen d'étanchéité sont formés en une seule pièce.

20. Appareil de chauffage selon la revendication 18 ou 19, **caractérisé en ce que** l'échangeur de chaleur et le matériau isolant de chaleur et/ou le moyen d'étanchéité sont formés en une seule pièce.

21. Appareil de chauffage selon l'une des revendications précédentes, **caractérisé en ce qu'**un moyen conducteur de chaleur est prévu entre le dispositif thermoélectrique et le paroi (12) et/ou entre le dispositif thermoélectrique et l'échangeur de chaleur (26).

22. Appareil de chauffage selon la revendication 21, **caractérisé en ce que** le moyen conducteur de chaleur comporte une pâte conductrice de chaleur.

23. Appareil de chauffage selon la revendication 21, **caractérisé en ce que** le moyen conducteur de chaleur comporte une feuille conductrice de chaleur.
